# EUROPEAN PATENT APPLICATION

(11) **EP 4 654 804 A1**
(43) Date of publication of application: **26.11.2025**
(21) Application number: 23926780.0
(22) Date of filing: 15.03.2023
(51) Int. Cl.: H10K 71/00

(54) **METHOD FOR PREPARING PEROVSKITE FILM LAYER, PEROVSKITE FILM LAYER, AND SOLAR CELL**

(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: GU, Shuai, Shanghai 201100 (CN); LIU, Tianyu, Shanghai 201100 (CN); LI, Yaru, Shanghai 201100 (CN); CHEN, Chen, Shanghai 201100 (CN); JIA, Boyu, Shanghai 201100 (CN); GUO, Yongsheng, Shanghai 201100 (CN); CHEN, Junchao, Shanghai 201100 (CN); CHEN, Guodong, Shanghai 201100 (CN)
(74) Representative: Jacob, Reuben Ellis
(86) International application number: PCT/CN2023/081720
(87) International publication number: WO 2024/187424

(57) **Abstract**

The present application provides a method for a perovskite film layer. The method comprises: providing a substrate and a transport layer disposed on the substrate; depositing a perovskite reactive material layer on the side of the transport layer distal to the substrate to give an intermediate product, wherein before depositing the perovskite reactive material layer, the method further comprises depositing a first precursor-passivating layer, and/or after depositing the perovskite reactive material layer, the method further comprises depositing a second precursor-passivating layer; and placing the intermediate product in a solvent atmosphere for reaction. The present application further provides a perovskite film layer and a solar cell. According to the method provided in the present application, the precursor in the passivating layers and the perovskite reactive material layer are formed through deposition, and then a reaction environment is provided by using the solvent atmosphere, such that the precursor in the passivating layers reacts with the perovskite reactive material, thus avoiding the defect that the film layers all require annealing in the preparation process and achieving the preparation of the perovskite film layers with a simple process.

## Description

### TECHNICAL FIELD

This application relates to the field of solar cell technologies, and in particular to, a preparation method of a perovskite film layer, a perovskite film layer, and a solar cell.

### BACKGROUND

Perovskite solar cells refer to cells that use perovskite materials as materials of light-absorbing layers. Due to the significant performance advantages of perovskite materials, such as high light absorption coefficient, carrier mobility, and direct and tunable optical bandgap, perovskite solar cells have gained widespread attention and rapid development. However, in existing preparation methods of perovskite film layers, each film layer needs to be annealed during the preparation process, resulting in a complex process.

Therefore, how to propose a simple-process preparation method of a perovskite film layer, a perovskite film layer, and a solar cell is an urgent problem to be solved.

### SUMMARY

In view of the above problems, this application provides a simple-process preparation method of a perovskite film layer, a perovskite film layer, and a solar cell.

According to first aspect, this application provides a preparation method of a perovskite film layer, including the following steps:
providing a substrate, where the substrate includes a base and a transport layer disposed on the base;
depositing a perovskite reaction material layer on a side of the transport layer facing away from the base to obtain an intermediate product, where before depositing the perovskite reaction material layer, deposition of a first passivation precursor layer is further included, and/or after depositing the perovskite reaction material layer, deposition of a second passivation precursor layer is further included; and
placing the intermediate product in a solvent atmosphere for reaction.

In the technical solutions of the embodiments of this application, a structure of a first passivation precursor layer/perovskite reaction material layer, a structure of a first passivation precursor layer/perovskite reaction material layer/second passivation precursor layer, or a structure of a perovskite reaction material layer/second passivation precursor layer is formed by deposition, and then a solvent atmosphere is utilized to provide a reaction environment, enabling the first passivation precursor layer and/or the second passivation precursor layer to react with the perovskite reaction material, avoiding the defect that each film layer needs to be annealed during the preparation process, achieving the preparation of the perovskite film layer, and providing a simple-process preparation method of a perovskite film layer.

In addition, since the preparation method of a perovskite film layer provided by this application avoids the defect that each film layer needs to be annealed during the preparation process and achieves the preparation of the perovskite film layer, the preparation cycle and cost of the perovskite film layer are reduced, enabling large-scale continuous production.

Furthermore, by utilizing the solvent atmosphere to provide the reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer.

In some embodiments, the transport layer includes an electron transport layer or a hole transport layer.

In the technical solutions of the embodiments of this application, the electron transport layer has a function of transporting electrons and blocking electron-hole recombination, and the hole transport layer has a function of transporting holes and blocking electrons. The electron transport layer or hole transport layer can ensure that devices using the perovskite film layer have higher efficiency. In a regular device, the transport layer is an electron transport layer; and in an inverted device, the transport layer is a hole transport layer.

In some embodiments, a material of the electron transport layer includes at least one of TiO₂, SnO₂, and ZnO, and a material of the hole transport layer includes at least one of poly [bis(4-phenyl)(2,4,6-trimethylphenyl)amine] (Poly[bis(4-phenyl)(2,4,6-triMethylphenyl)amine], PTAA), poly(3,4-ethylenedioxythiophene):poly(styrenesulfonate) (Poly(3,4-ethylenedioxythiophene):poly(styrenesulfonate), PEDOT:PSS), triphenylamine, carbazole phosphate, and NiOₓ.

In the technical solutions of the embodiments of this application, TiO₂, SnO₂, ZnO, PTAA, PEDOT:PSS, triphenylamine, carbazole phosphate, and NiOₓ all have good stability and are easy to prepare.

In some embodiments, the first passivation precursor layer, the perovskite reaction material layer, and/or the second passivation precursor layer are deposited by a vapor deposition method.

In the technical solutions of the embodiments of this application, depositing the first passivation precursor layer, the perovskite reaction material layer, and the second passivation precursor layer by the vapor deposition method has low dependence on substrate morphology, material solubility, and solvent wettability. This method not only offers high precision and good repeatability but also has significant applicability advantages. Moreover, this method can expand the types of substrates and optional ranges of materials for perovskite film layers in perovskite devices, providing more optimization directions for the field of perovskite devices.

In some embodiments, the solvent atmosphere includes a polar solvent.

In the technical solutions of the embodiments of this application, the solvent atmosphere includes a polar solvent, the polar solvent has good solubility and can dissolve numerous inorganic and organic compounds, and the polar solvent has good thermal and chemical stability.

In some embodiments, the solvent atmosphere includes at least one of vapor phases of N,N-dimethylformamide (N,N-Dimethylformamide, DMF), dimethyl sulfoxide (Dimethyl sulfoxide, DMSO), N-methylpyrrolidone (N-Methylpyrrolidone, NMP), dimethylacetamide (Dimethylacetamide, DMAC), 1,4-butyrolactone (1,4-Butyrolactone, GBL), and 1,3-dimethyl-2-imidazolidinone (1,3-Dimethyl-2-imidazolidinone, DMI).

In the technical solutions of the embodiments of this application, with a solvent atmosphere of DMF, DMSO, NMP, DMAC, GBL, or DMI used as the reaction environment, this method is easy to implement. Moreover, DMF, DMSO, NMP, DMAC, GBL, and DMI all have good solubility and can dissolve numerous inorganic and organic compounds; and DMF, DMSO, NMP, DMAC, GBL, and DMI have good thermal and chemical stability.

In some embodiments, the solvent atmosphere is provided by a semi-closed container or a gas flow environment.

In the technical solutions of the embodiments of this application, this method of providing the solvent atmosphere through the semi-closed container or the gas flow environment is simple and easy to operate.

In some embodiments, a solvent is added to the semi-closed container, and the semi-closed container is heated to form a solvent atmosphere.

In the technical solutions of the embodiments of this application, the solvent is added to the semi-closed container, and the semi-closed container is heated to form the solvent atmosphere, which can not only provide a solvent atmosphere for the precursor materials to react, but also avoid a continuous increase in local concentration while ensuring atmosphere uniformity.

In some embodiments, a concentration of the solvent atmosphere is 2-20 mg/m³.

If the concentration of the solvent atmosphere is too low, for example, below 2 mg/m³, there is insufficient solvent atmosphere to provide a reaction environment, thereby affecting the reaction velocity. If the concentration of the solvent atmosphere is too high, for example, above 20 mg/m³, excessive solvent will dissolve the perovskite precursor material, affecting the crystallization process, leading to rough morphology and being detrimental to device performance. Therefore, in the technical solutions of the embodiments of this application, controlling the concentration of the solvent atmosphere to be 2-20 mg/m³ can improve the device performance while ensuring the reaction velocity.

In some embodiments, a material of the first passivation precursor layer and a material of the second passivation precursor layer are selected from at least one of an organic halide and a metal halide, and the material of the first passivation precursor layer is different from the material of the second passivation precursor layer.

In the technical solutions of the embodiments of this application, an interface between the organic halide and the perovskite reaction material layer and an interface between metal halide and the perovskite reaction material layer can form a perovskite structure, thereby increasing interface bonding, enabling the perovskite devices prepared by this method to have good photoelectric performance.

In some embodiments, the organic halide includes at least one of benzylamine, phenylethylamine, diphenylamine, spermine, naphthylamine, and halogenated derivatives thereof.

In the technical solutions of the embodiments of this application, the material type of the organic halide is further limited, and the bonding at the interface between the organic halide and the perovskite reaction material layer is optimized, enabling the perovskite devices prepared by this method to have good photoelectric performance.

In some embodiments, the metal halide includes halides of trivalent metal elements in the same period as Pb and Sn.

In the technical solutions of the embodiments of this application, the material type of the metal halide is further limited, and the bonding at the interface between the metal halide and the perovskite reaction material layer is optimized, enabling the perovskite devices prepared by this method to have good photoelectric performance.

In some embodiments, the perovskite reaction material layer includes BX₂ and AX, where B includes at least one of Sn and Pb, A includes at least one of Cs, FA, and MA, X includes at least one of Cl, Br, and I, the organic halide is close to a side of BX₂ side, and the metal halide is close to a side of AX.

In the technical solutions of the embodiments of this application, the type of the material in the perovskite reaction material layer is further limited, and a positional relationship between the organic halide and the perovskite reaction material layer and a positional relationship between the metal halide and the perovskite reaction material layer are limited, and the bonding at the interface between the organic halide and the perovskite reaction material layer and the interface between the metal halide and the perovskite reaction material layer is optimized, enabling the perovskite devices prepared by this method to have good photoelectric performance.

In some embodiments, a thickness of the first passivation precursor layer is 5-20 nm.

If the thickness of the first passivation precursor layer is too small, for example, less than 5 nm, during reaction in the solvent atmosphere, the defects in the perovskite reaction material layer cannot be effectively passivated, and charge transport cannot be effectively enhanced. If the thickness of the first passivation precursor layer is too large, for example, greater than 20 nm, the conductivity of the device after formation the first passivation layer is reduced, affecting the device performance. Controlling the thickness of the first passivation precursor layer to be 5-20 nm can passivate the defects in the perovskite reaction material layer and enhance charge transport while ensuring conductivity, thereby improving the photoelectric performance of the perovskite device.

In some embodiments, a thickness of the second passivation precursor layer is 5-20 nm.

If the thickness of the second passivation precursor layer is too small, for example, less than 5 nm, during reaction in the solvent atmosphere, the defects in the perovskite layer cannot be effectively passivated, and charge transport cannot be effectively enhanced. If the thickness of the second passivation precursor layer is too large, for example, greater than 20 nm, the conductivity of the device after formation of the second passivation layer is reduced, affecting the device performance. Controlling the thickness of the second passivation precursor layer to be 5-20 nm can passivate the defects in the perovskite reaction material layer and enhance charge transport while ensuring conductivity, thereby improving the photoelectric performance of the perovskite device.

In some embodiments, a thickness of the perovskite reaction material layer is 400-800 nm.

If the thickness of the perovskite reaction material layer is less than 400 nm, the thickness of the perovskite material layer formed from the perovskite reaction material layer is insufficient to fully absorb sunlight, resulting in a smaller current in the perovskite device. If the thickness of the perovskite reaction material layer is greater than 800 nm, the thickness of the perovskite material layer formed from the perovskite reaction material layer is too large, leading to premature recombination of carriers in the perovskite device, and making effective separation impossible. Therefore, the thickness of the perovskite reaction material layer being 400-800 nm allows the formed perovskite device to have excellent photoelectric performance.

In some embodiments, the base includes at least one of a polyethylene terephthalate (polyethylene terephthalate, PET) base, a textured silicon base, or a glass base.

In the technical solutions of the embodiments of this application, there are various types of bases, which can be applied to devices with different requirements, and the costs of the PET bases, textured silicon bases, and glass bases are relatively low.

In some embodiments, a conductive layer is provided between the base and the transport layer.

In the technical solutions of the embodiments of this application, providing a conductive layer on a surface of the base enables the base to have good conductivity, which can serve as a conductive electrode for devices such as perovskite solar cells.

According to a second aspect, this application further provides a perovskite film layer, including:
a perovskite material layer; and
a first passivation layer and/or a second passivation layer,
where the first passivation layer is disposed on a surface of the perovskite material layer close to a base, the second passivation layer is disposed on a surface of the perovskite material layer facing away from the base, and a grain size of the perovskite material layer is greater than or equal to 2 micrometers.

In the technical solutions of the embodiments of this application, utilizing a solvent atmosphere to provide a reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer. The perovskite material layer has a large grain size, good crystallization performance, and fewer defects at grain boundaries, thereby enhancing the stability of the perovskite film layer.

According to third aspect, this application further provides a perovskite film layer including a perovskite film layer obtained by the preparation method of a perovskite film layer according to any one of the foregoing embodiments, where the perovskite film layer includes:
a perovskite material layer; and
a first passivation layer and/or a second passivation layer,
where the first passivation layer is disposed on a surface of the perovskite material layer close to a base, and the second passivation layer is disposed on a surface of the perovskite material layer facing away from the base.

In the technical solutions of the embodiments of this application, utilizing a solvent atmosphere to provide a reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer. The resulting perovskite material layer has a large grain size, good crystallization performance, and fewer defects at grain boundaries, thereby enhancing the stability of the perovskite film layer.

According to a fourth aspect, this application further provides a solar cell including the perovskite film layer as described above or a perovskite film layer prepared by the preparation method of a perovskite film layer according to any one of the foregoing embodiments.

The foregoing description is merely an overview of the technical solutions of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings in the following description show merely some embodiments of this application, and persons of ordinary skill in the art may still derive other drawings from the accompanying drawings without creative efforts.
FIG. 1 is a flowchart of a preparation method of a perovskite film layer according to some embodiments of this application;
FIG. 2 is a schematic structural diagram of a solar cell according to some embodiments of this application;
FIG. 3 is a schematic structural diagram of a solar cell according to some embodiments of this application;
FIG. 4 is a schematic structural diagram of a solar cell according to some embodiments of this application;
FIG. 5 is a schematic structural diagram of a solar cell according to some embodiments of this application; and
FIG. 6 is a schematic structural diagram of a solar cell according to some embodiments of this application.

The accompanying drawings are not drawn to scale.

Description of reference signs: solar cell 10;
base 101; conductive layer 102; electron transport layer 105; perovskite film layer 104; hole transport layer 103; metal electrode 106; first passivation layer 1041; perovskite material layer 1042; and second passivation layer 1043.

### DESCRIPTION OF EMBODIMENTS

The following describes in detail embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein have the same meaning as commonly understood by persons skilled in the technical field of this application. The terms used herein are only for the purpose of describing specific embodiments and are not intended to limit this application. The terms "include", "comprise", "have", and any variations thereof in the specification, claims, and the above description of the drawings of this application are intended to cover non-exclusive inclusion.

In the description of the embodiments of this application, the technical terms "first", "second", and the like are only used to distinguish different objects and should not be understood as indicating or implying relative importance or implicitly indicating the number, specific order, or primary-secondary relationship of the indicated technical features.

Reference to "embodiment" herein means that a specific feature, structure, or characteristic described in connection with the embodiment may be included in at least one embodiment of this application. The word "embodiment" appearing in various places in this specification does not necessarily refer to the same embodiment or an independent or alternative embodiment that is exclusive of other embodiments. Persons skilled in the art explicitly and implicitly understand that the embodiments described herein can be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between the contextually associated objects.

Currently, from the perspective of market development trends, the application of perovskite solar cells is becoming increasingly widespread. Perovskite solar cells can be applied to lunar rovers, satellite solar panels, various sensors, detectors, as well as civilian products such as wearable electronic products and automotive power supplies, making perovskite solar cells become power sources for consumer goods in many aspects. With the continuous expansion of the application fields of perovskite solar cells and flexible foldability of the perovskite solar cells, the market demand for the perovskite solar cells is also constantly increasing.

In existing preparation methods of perovskite film layers, each film layer needs to be annealed during the preparation process, resulting in a complex process.

To solve the above technical problems, the present invention designs a preparation method of a perovskite film layer, where a structure of a first passivation precursor layer/perovskite reaction material layer, a structure of a first passivation precursor layer/perovskite reaction material layer/second passivation precursor layer, or a structure of a perovskite reaction material layer/second passivation precursor layer are formed by deposition, and then a solvent atmosphere is utilized to provide a reaction environment, enabling the first passivation precursor layer and/or the second passivation precursor layer to react with the perovskite reaction material, avoiding the defect that each film layer needs to be annealed during the preparation process, achieving the preparation of the perovskite film layer, and providing a simple-process preparation method of a perovskite film layer.

In addition, since the preparation method of a perovskite film layer provided by this application avoids the defect that each film layer needs to be annealed during the preparation process and achieves the preparation of the perovskite film layer, the preparation cycles and costs of a perovskite light-absorbing layer and interface passivation are reduced, enabling large-scale continuous production.

Furthermore, by utilizing the solvent atmosphere to provide the reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer.

Based on the above considerations, to simplify the process of the preparation method of the perovskite film layer, a preparation method of a perovskite film layer is designed, including the following steps:
providing a substrate, where the substrate includes a base and a transport layer disposed on the base;
depositing a perovskite reaction material layer on a side of the transport layer facing away from the base to obtain an intermediate product, where before depositing the perovskite reaction material layer, deposition of a first passivation precursor layer is further included, and/or after depositing the perovskite reaction material layer, deposition of a second passivation precursor layer is further included; and
placing the intermediate product in a solvent atmosphere for reaction.

After the intermediate product reacts in the solvent atmosphere, the first passivation precursor layer forms a first passivation layer, the perovskite reaction material layer forms a perovskite material layer, and the second passivation precursor layer forms a second passivation layer.

In the technical solutions of the embodiments of this application, a structure of a first passivation precursor layer/perovskite reaction material layer, a structure of a first passivation precursor layer/perovskite reaction material layer/second passivation precursor layer, or a structure of a perovskite reaction material layer/second passivation precursor layer is formed by deposition, and then a solvent atmosphere is utilized to provide a reaction environment, enabling the first passivation precursor layer and/or the second passivation precursor layer to react with the perovskite reaction material, avoiding the defect that each film layer needs to be annealed during the preparation process, achieving the preparation of the perovskite film layer, and providing a simple-process preparation method of a perovskite film layer.

In addition, since the preparation method of a perovskite film layer provided by this application avoids the defect that each film layer needs to be annealed during the preparation process and achieves the preparation of the perovskite film layer, the preparation cycles and costs of the perovskite light-absorbing layer are reduced, enabling large-scale continuous production.

Furthermore, by utilizing a solvent atmosphere to provide a reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer.

The embodiments of this application will be described in detail below in conjunction with the drawings and embodiments.

The technical solutions described in the embodiments of this application are applicable to perovskite light-absorbing layers, solar cells, and electric apparatuses. The solar cells disclosed in this application can be used in perovskite tandem solar cells and silicon-perovskite tandem solar cells, without limitation by this application.

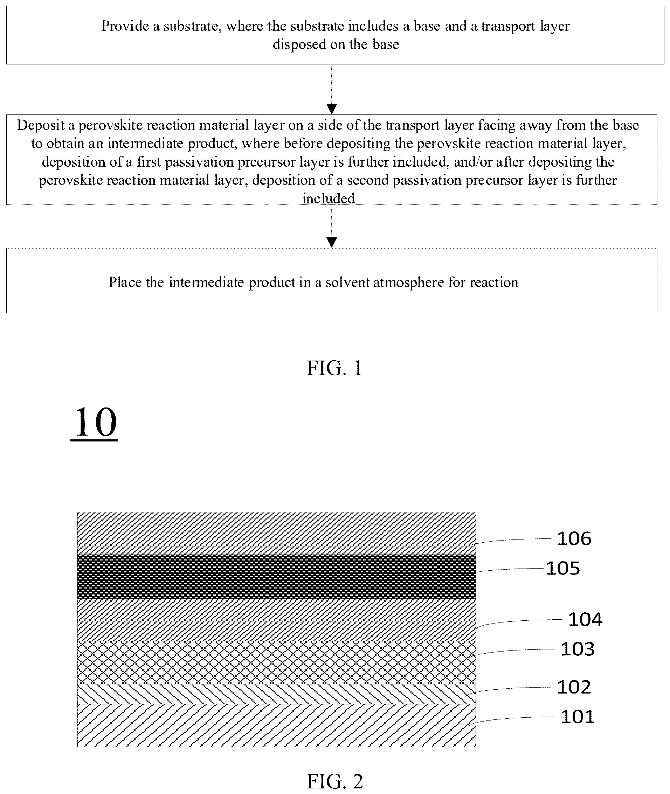

Referring to FIG. 1, according to some embodiments of this application, this application provides a preparation method of a perovskite film layer, including the following steps:
providing a substrate, where the substrate includes a base and a transport layer disposed on the base;
depositing a perovskite reaction material layer on a side of the transport layer facing away from the base to obtain an intermediate product, where before depositing the perovskite reaction material layer, deposition of a first passivation precursor layer is further included, and/or after depositing the perovskite reaction material layer, deposition of a second passivation precursor layer is further included; and
placing the intermediate product in a solvent atmosphere for reaction.

In some embodiments, the first passivation precursor layer is deposited on the side of the transport layer facing away from the base, then the perovskite reaction material layer is deposited on a side of the first passivation precursor layer facing away from the transport layer to obtain the intermediate product, and the intermediate product is placed in the solvent atmosphere for reaction.

In some embodiments, the first passivation precursor layer is deposited on the side of the transport layer facing away from the base, the perovskite reaction material layer is deposited on the side of the first passivation precursor layer facing away from the transport layer, then the second passivation precursor layer is deposited on a side of the perovskite reaction material layer facing away from the first passivation precursor layer to obtain the intermediate product, and the intermediate product is placed in the solvent atmosphere for reaction.

In some embodiments, the perovskite reaction material layer is deposited on the side of the transport layer facing away from the base, then the second passivation precursor layer is deposited on a side of the perovskite reaction material layer facing away from the transport layer to obtain the intermediate product, and the intermediate product is placed in the solvent atmosphere for reaction.

A structure of a first passivation precursor layer/perovskite reaction material layer, a structure of a first passivation precursor layer/perovskite reaction material layer/second passivation precursor layer, or a structure of a perovskite reaction material layer/second passivation precursor layer is formed by deposition, and then a solvent atmosphere is utilized to provide a reaction environment, enabling the first passivation precursor layer and/or the second passivation precursor layer to react with the perovskite reaction material, avoiding the defect that each film layer needs to be annealed during the preparation process, achieving the preparation of the perovskite film layer, and providing a simple-process preparation method for a perovskite film layer.

In addition, since the preparation method of the perovskite film layer provided by this application avoids the defect that each film layer needs to be annealed during the preparation process and achieves the preparation of the perovskite film layer, the preparation cycles and costs of the perovskite light-absorbing layer are reduced, enabling large-scale continuous production.

Furthermore, by utilizing the solvent atmosphere to provide the reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer.

According to some embodiments of this application, the transport layer includes an electron transport layer or a hole transport layer.

The electron transport layer has a function of transporting electrons and blocking electron-hole recombination, and the hole transport layer has a function of transporting holes and blocking electrons. The electron transport layer or hole transport layer can ensure that devices using the perovskite film layer have higher efficiency.

According to some embodiments of this application, a material of the electron transport layer includes at least one of TiO₂, SnO₂, and ZnO, and a material of the hole transport layer includes at least one of poly[bis(4-phenyl)(2,4,6-trimethylphenyl)amine] (Poly[bis(4-phenyl)(2,4,6-triMethylphenyl)amine], PTAA), poly(3,4-ethylenedioxythiophene):poly(styrenesulfonate) (Poly(3,4-ethylenedioxythiophene):poly(styrenesulfonate), PEDOT:PSS), triphenylamine, carbazole phosphate, and NiOₓ.

Triphenylamine may be N4,N4'-di(naphthalen-1-yl)-N4,N4'-bis(4-vinylphenyl)biphenyl-4,4'-diamine (N,N'-Bis(naphthalen-1-yl)-N,N'-bis(4-vinyl-phenyl)benzidine, VNPB), PTAA, N,N-diphenyl-4-(pyridin-4-yl) aniline (N,N-diphenyl-4-(pyridin-4-yl)aniline, (p-PY)), or the like.

Carbazole phosphate may be (2-(9H-carbazol-9-yl)ethyl)phosphonic acid (Phosphonic acid, (2-carbazol-9-ylethyl)-(8CI), 2PACz), (2-(3,6-dimethyl-9H-carbazol-9-yl)ethyl)phosphonic acid (2-(3,6-Dimethyl-9H-carbazol-9-yl)ethyl)phosphonic acid, Me-2PACz), (2-(3,6-dimethoxy-9H-carbazol-9-yl)ethyl)phosphonic acid (P-[2-(3,6-dimethoxy-9H-carbazol-9-yl)ethyl]-Phosphonic acid, MeO-2PACz), or the like.

TiO₂, SnO₂, and ZnO have good electron transport properties; PTAA, PEDOT:PSS, triphenylamine, carbazole phosphate, and NiOₓ have good hole transport properties; and TiO₂, SnO₂, ZnO, PTAA, PEDOT:PSS, triphenylamine, carbazole phosphate, and NiOₓ all have good stability and are easy to prepare.

According to some embodiments of this application, the first passivation precursor layer, the perovskite reaction material, and/or the second passivation precursor layer are deposited by a vapor deposition method.

Depositing the first passivation precursor layer, the perovskite reaction material layer, and the second passivation precursor layer by the vapor deposition method has low dependence on substrate morphology, material solubility, and solvent wettability. This method not only offers high precision and good repeatability but also has significant applicability advantages. Moreover, this method can expand the types of substrates and optional ranges of materials for perovskite film layers in perovskite devices, providing more optimization directions for the field of perovskite devices.

According to some embodiments of this application, the solvent atmosphere includes a polar solvent.

The solvent atmosphere includes a polar solvent, the polar solvent has good solubility and can dissolve numerous inorganic and organic compounds, and the polar solvent has good thermal and chemical stability.

According to some embodiments of this application, the solvent atmosphere includes at least one of vapor phases of N,N-dimethylformamide (N,N-Dimethylformamide, DMF), dimethyl sulfoxide (Dimethyl sulfoxide, DMSO), N-methylpyrrolidone (N-Methylpyrrolidone, NMP), dimethylacetamide (Dimethylacetamide, DMAC), 1,4-butyrolactone (1,4-Butyrolactone, GBL), and 1,3-dimethyl-2-imidazolidinone (1,3-Dimethyl-2-imidazolidinone, DMI).

With a solvent atmosphere of DMF, DMSO, NMP, DMAC, GBL, or DMI used as the reaction environment, this method is easy to implement. Moreover, DMF, DMSO, NMP, DMAC, GBL, and DMI all have good solubility and can dissolve numerous inorganic and organic compounds; and DMF, DMSO, NMP, DMAC, GBL, and DMI have good thermal and chemical stability.

According to some embodiments of this application, the solvent atmosphere is provided by a semi-closed container or a gas flow environment.

As an example, the semi-closed container includes but is not limited to a beaker, and the gas flow environment includes but is not limited to a tubular environment.

This method of providing the solvent atmosphere through the semi-closed container or the gas flow environment is simple and easy to operate.

According to some embodiments of this application, a solvent is added to the semi-closed container, and the semi-closed container is heated to form a solvent atmosphere.

The solvent is added to the semi-closed container, and the semi-closed container is heated to form the solvent atmosphere, which can not only provide a solvent atmosphere for the precursor materials to react, but also avoid a continuous increase in local concentration while ensuring atmosphere uniformity. As an example, the solvent can be dropped into the semi-closed container.

In some embodiments, a concentration of the solvent atmosphere can be 2-20 mg/m³.

As an example, the concentration of the solvent atmosphere may be 2 mg/m³, 3.5 mg/m³, 5 mg/m³, 7.5 mg/m³, 11 mg/m³, 14.5 mg/m³, 17 mg/m³, 19.5 mg/m³, 20 mg/m³, or the like. The concentration of the solvent atmosphere may alternatively be 2-3.5 mg/m³, 3.5-5 mg/m³, 5-7.5 mg/m³, 7.5-11 mg/m³, 11-14.5 mg/m³, 14.5-17 mg/m³, 17-19.5 mg/m³, 19.5-20 mg/m³, 20 mg/m³, or the like. The concentration of the solvent atmosphere is selected according to actual needs, as long as it falls within the range of 2-20 mg/m³.

If the concentration of the solvent atmosphere is too low, for example, below 2 mg/m³, there is insufficient solvent atmosphere to provide a reaction environment, thereby affecting the reaction velocity. If the concentration of the solvent atmosphere is too high, for example, above 20 mg/m³, excessive solvent will dissolve the perovskite precursor material, affecting the crystallization process, leading to rough morphology and being detrimental to device performance. Therefore, in the technical solutions of the embodiments of this application, controlling the concentration of the solvent atmosphere to be 2-20 mg/m³ can improve the device performance while ensuring the reaction velocity.

In some embodiments, the solvent atmosphere includes a DMSO solvent atmosphere, and a concentration range of the DMSO solvent atmosphere may be 2-10 mg/m³. In some embodiments, the solvent atmosphere includes an NMP solvent atmosphere, and a concentration range of the NMP solvent atmosphere may be 5-15 mg/m³. In some embodiments, the solvent atmosphere includes a DMF solvent atmosphere, and a concentration range of the DMF solvent atmosphere can be 2-10 mg/m³.

A material of the first passivation precursor layer and a material of the second passivation precursor layer can be selected according to actual needs. According to some embodiments of this application, the material of the first passivation precursor layer and the material of the second passivation precursor layer are selected from but not limited to at least one of an organic halide and a metal halide, and the material of the first passivation precursor layer is different from the material of the second passivation precursor layer.

The interface between the organic halide and the perovskite reaction material layer and the interface between the metal halide and the perovskite reaction material layer can form a perovskite structure, thereby increasing interface bonding, enabling the perovskite devices prepared by this method to have good photoelectric performance.

According to some embodiments of this application, the organic halide includes but is not limited to at least one of benzylamine, phenylethylamine, diphenylamine, spermine, naphthylamine, and halogenated derivatives thereof.

The material type of the organic halide is further limited, and the bonding at the interface between the organic halide and the perovskite reaction material layer is optimized, enabling the perovskite devices prepared by this method to have good photoelectric performance.

According to some embodiments of this application, the metal halide includes but is not limited to halides of trivalent metal elements in the same period as Pb and Sn.

The material type of the metal halide is further limited, and the bonding at the interface between the metal halide and the perovskite reaction material layer is optimized, enabling the perovskite devices prepared by this method to have good photoelectric performance.

According to some embodiments of this application, the perovskite reaction material layer includes BX₂ and AX, where B includes at least one of Sn and Pb, A includes at least one of Cs, FA, and MA, X includes at least one of Cl, Br, and I, the organic halide is close to a side of BX₂, and the metal halide is close to a side of AX.

The type of the material in the perovskite reaction material layer is further limited, and a positional relationship between the organic halide and the perovskite reaction material layer and a positional relationship between the metal halide and the perovskite reaction material layer are limited, and the bonding at the interface between the organic halide the perovskite reaction material layer and the interface between the metal halide and the perovskite reaction material layer is optimized, enabling the perovskite devices prepared by this method to have good photoelectric performance.

According to some preferred embodiments of this application, a thickness of the first passivation precursor layer is 5-20 nm.

As an example, the thickness of the first passivation precursor layer may be 5 nm, 7.5 nm, 10 nm, 11 nm, 14.5 nm, 16 nm, 18.5 nm, 19.9 nm, 20 nm, etc., or it can be 5-7.5 nm, 7.5-10 nm, 10-11 nm, 11-14.5 nm, 14.5-16 nm, 16-18.5 nm, 18.5-19.9 nm, 19.9-20 nm, or the like, and is selected according to actual needs, as long as it falls within the range of 5-20 nm.

If the thickness of the first passivation precursor layer is too small, for example, less than 5 nm, during reaction in the solvent atmosphere, the defects in the perovskite layer cannot be effectively passivated, and charge transport cannot be effectively enhanced. If the thickness of the first passivation precursor layer is too large, for example, greater than 20 nm, the conductivity of the device after formation of the first passivation layer is reduced, affecting the device performance. Controlling the thickness of the first passivation precursor layer to be 5-20 nm can passivate the defects in the perovskite reaction material layer and enhance charge transport while ensuring conductivity, thereby improving the photoelectric performance of the perovskite device.

Certainly, the thickness of the first passivation precursor layer is not limited to 5-20 nm. In some other embodiments, the thickness of the first passivation precursor layer may alternatively be another thickness selected according to actual needs. For example, the thickness of the first passivation precursor layer can be selected based on the type of the material of the first passivation precursor layer.

A thickness of the second passivation precursor layer may be the same as or different from the thickness of the first passivation precursor layer. According to some preferred embodiments of this application, the thickness of the second passivation precursor layer is 5-20 nm.

As an example, the thickness of the second passivation precursor layer may be 5 nm, 7.5 nm, 10 nm, 11 nm, 14.5 nm, 16 nm, 18.5 nm, 19.9 nm, 20 nm, etc., or it can be 5-7.5 nm, 7.5-10 nm, 10-11 nm, 11-14.5 nm, 14.5-16 nm, 16-18.5 nm, 18.5-19.9 nm, 19.9-20 nm, or the like, and is selected according to actual needs, as long as it falls within the range of 5-20 nm.

If the thickness of the second passivation precursor layer is too small, for example, less than 5 nm, during reaction in the solvent atmosphere, the defects in the perovskite layer cannot be effectively passivated, and charge transport cannot be effectively enhanced. If the thickness of the second passivation precursor layer is too large, for example, greater than 20 nm, the conductivity of the device after formation of the second passivation layer is reduced, affecting the device performance. Controlling the thickness of the second passivation precursor layer to be 5-20 nm can passivate the defects in the perovskite reaction material layer and enhance charge transport while ensuring conductivity, thereby improving the photoelectric performance of the perovskite device.

Certainly, the thickness of the second passivation precursor layer is not limited to 5-20 nm. In some other embodiments, the thickness of the second passivation precursor layer may alternatively be another thickness selected according to actual needs. For example, the thickness of the second passivation precursor layer can be selected based on the type of the material of the second passivation precursor layer.

In some embodiments, a thickness of the perovskite reaction material layer is 400-800 nm.

As an example, the thickness of the perovskite reaction material layer may be 400 nm, 450 nm, 460 nm, 550 nm, 650 nm, 800 nm, etc., or it can be 400-450 nm, 450-460 nm, 460-550 nm, 550-650 nm, 650-800 nm, 800 nm, or the like, and is selected according to actual needs, as long as it falls within the range of 400-800 nm.

If the thickness of the perovskite reaction material layer is less than 400 nm, the thickness of the perovskite material layer formed from the perovskite reaction material layer is insufficient to fully absorb sunlight, resulting in a smaller current in the perovskite device. If the thickness of the perovskite reaction material layer is greater than 800 nm, the thickness of the perovskite material layer formed from the perovskite reaction material layer is too large, leading to premature recombination of carriers in the perovskite device, and making effective separation impossible. Therefore, the thickness of the perovskite reaction material layer results being 400-800 nm allows the formed perovskite device to have excellent photoelectric performance.

According to some embodiments of this application, the base includes but is not limited to at least one of a polyethylene terephthalate (polyethylene terephthalate, PET) base, a textured silicon base, or a glass base.

There are various types of bases, which can be applied to devices with different requirements, and the costs of the PET bases, textured silicon bases, and glass bases are relatively low.

According to some embodiments of this application, a conductive layer is provided between the base and the transport layer.

A material of the conductive layer is preferably but not limited to a material with high conductivity and high visible light transmittance. As an example, the material of the conductive layer includes but is not limited to F-doped tin oxide (F-doped tin oxide, FTO), indium tin oxide (Indium tin oxides, ITO), aluminum zinc oxide (Aluminum zinc oxide, AZO), boron zinc oxide (Boron zinc oxide, BZO), indium zinc oxide (Indium zinc oxide, IZO), or the like.

Providing a conductive layer on a surface of the base enables the base to have good conductivity, which can serve as a conductive electrode for devices such as perovskite solar cells.

According to some embodiments of this application, a perovskite film layer is also provided, including:
a perovskite material layer; and
a first passivation layer and/or a second passivation layer,
where the first passivation layer is disposed on a surface of the perovskite material layer close to a base, the second passivation layer is disposed on a surface of the perovskite material layer facing away from the base, and a grain size of the perovskite material layer is greater than or equal to 2 micrometers.

According to some embodiments of this application, the perovskite material layer in the perovskite film layer may include zero-dimensional, one-dimensional, and/or two-dimensional materials.

Utilizing a solvent atmosphere to provide a reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer.

The grain size of the perovskite material layer being greater than or equal to 2 micrometers means that a grain size in a direction perpendicular to the thickness of the perovskite material layer is greater than or equal to 2 micrometers.

The perovskite material layer has a large grain size, good crystallization performance, and fewer defects at grain boundaries, thereby enhancing the stability of the perovskite film layer.

According to some embodiments of this application, this application further provides a perovskite film layer, including a perovskite film layer obtained by the preparation method of a perovskite film layer according to any one of the foregoing embodiments, where the perovskite film layer includes:
a perovskite material layer; and
a first passivation layer and/or a second passivation layer,
where the first passivation layer is disposed on a surface of the perovskite material layer close to a base, and the second passivation layer is disposed on a surface of the perovskite material layer facing away from the base.

In the technical solutions of the embodiments of this application, utilizing a solvent atmosphere to provide a reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer. The resulting perovskite material layer has a large grain size, good crystallization performance, and fewer defects at grain boundaries, thereby enhancing the stability of the perovskite film layer.

According to some embodiments of this application, this application further provides a solar cell, including the perovskite film layer according to any one of the foregoing embodiments or a perovskite film layer prepared by the preparation method of a perovskite film layer according to any one of the foregoing embodiments.

The perovskite film layer in any embodiment of this application can be applied to regular solar cells or inverted solar cells, both of which can improve the efficiency and commercial value of the corresponding solar cells.

In some embodiments, referring to FIG. 2, a solar cell 10 includes a base 101, a conductive layer 102, a hole transport layer 103, a perovskite film layer 104, an electron transport layer 105, and a metal electrode 106 stacked in sequence. The perovskite film layer 104 is the perovskite film layer according to any one of the foregoing embodiments. In these embodiments, the solar cell 10 is an inverted solar cell.

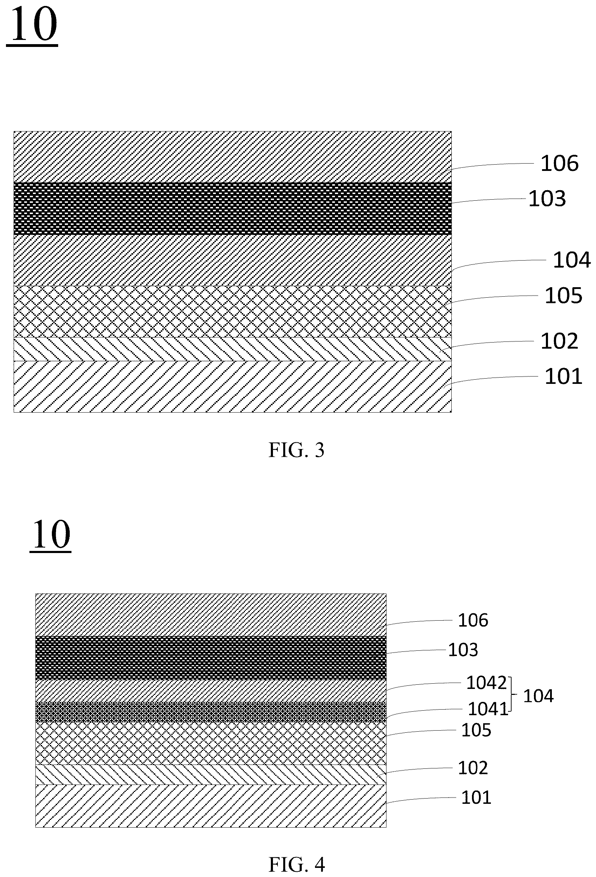

In some embodiments, referring to FIG. 3, a solar cell 10 includes a base 101, a conductive layer 102, an electron transport layer 105, a perovskite film layer 104, a hole transport layer 103, and a metal electrode 106 stacked in sequence. The perovskite film layer 104 is the perovskite film layer according to any one of the foregoing embodiments. In these embodiments, the solar cell 10 is a regular solar cell.

According to some embodiments of this application, this application further provides an electric apparatus including the solar cell provided by any one of the above solutions.

In this application, the solar cell serves as a power source for the above electric apparatus to supply power; alternatively, the solar cell can serve as an energy storage unit for the above electric apparatus. As an example, the electric apparatus may be a lighting element, a display element, an automobile, or the like.

The features and performance of this application will be further described in detail below in conjunction with examples.

### Example 1:

This example provides a preparation method of a perovskite film layer, including the following steps:
providing a substrate, where the substrate includes a PET base, an ITO conductive layer, and an SnO₂ electron transport layer stacked in sequence;
depositing a 10 nm thick PEAI layer as a first passivation precursor layer on a side of the SnO₂ electron transport layer facing away from the PET base by a vapor deposition method, and then depositing a 300 nm thick SnI₂ layer and a 150 nm thick MAI layer on a surface of the PEAI layer facing away from the SnO₂ electron transport layer by a vapor deposition method, the SnI₂ layer and the MAI layer being perovskite reaction material layers, to obtain an intermediate product; and
placing the intermediate product in a beaker, dropping a DMSO solvent with a concentration of 5 mg/m³ into the beaker, heating to 100°C to form a DMSO solvent atmosphere, and reacting in the DMSO solvent atmosphere at 100°C for 15 minutes.

The purity of the PEAI, SnI₂, and MAI materials used in Example 1 is not less than 99%. The first passivation precursor layer forms a first passivation layer, and the perovskite reaction material layer forms a perovskite material layer. The perovskite film layer obtained in Example 1 includes a first passivation layer and a perovskite material layer, where the first passivation layer is located at a first interface of the perovskite material layer close to the SnO₂ electron transport layer.

With the use of a semi-finished device including the perovskite film layer obtained in Example 1, the performance of the perovskite film layer prepared by the preparation method of Example 1 is verified. Referring to FIG. 4, a solar cell 10 includes a base 101, a conductive layer 102, an electron transport layer 105, a perovskite film layer 104, a hole transport layer 103, and an electrode 106 stacked in sequence. The base 101, the conductive layer 102, the electron transport layer 105, and the perovskite film layer 104 are each the semi-finished device including the perovskite film layer obtained in Example 1. The perovskite film layer 104 includes a first passivation layer 1041 and a perovskite material layer 1042, where the first passivation layer 1041 is located at an interface of the perovskite material layer 1042 close to the electron transport layer 105. The solar cell 10 in this example is a regular solar cell.

### Comparative example 1:

This comparative example 1 provides a preparation method of a perovskite film layer, including the following steps:
providing a substrate, where the substrate includes a PET base, an ITO conductive layer, and an SnO₂ electron transport layer stacked in sequence;
spin-coating a 3 mg/mL PEAl isopropanol solution on a surface of the SnO₂ electron transport layer facing away from the base by a solution method at a speed of 4000 rpm, and then depositing a 1.4 mol/L MASnI₃ by spin-coating to obtain an intermediate product; and
annealing the intermediate product at a temperature of 100°C for 30 minutes.

The purity of the PEAI and MASnI₃ materials used in Comparative example 1 is not less than 99%. Compared with the perovskite film layer obtained in Example 1, the perovskite film layer obtained in Comparative example 1 does not include a first passivation layer.

### Example 2:

This example provides a preparation method of a perovskite film layer, including the following steps:
providing a substrate, where the substrate includes a textured silicon base, an ITO conductive layer, and a PTAA hole transport layer stacked in sequence;
depositing a 350 nm thick PbI₂ layer and a 200 nm thick MAI layer as perovskite reaction material layers on a side of the PTAA hole transport layer facing away from the textured silicon base by a continuous vapor deposition method, and then depositing a 5 nm thick BiI₃ layer as a second passivation precursor layer on a surface of the perovskite reaction material layer facing away from the substrate by a physical vapor deposition method to obtain an intermediate product; and
placing the intermediate product at the bottom of a tubular furnace, heating the bottom of the tubular furnace while introducing an NMP solvent atmosphere with a concentration of 10 mg/m³ into the tubular furnace, controlling the temperature of the NMP solvent atmosphere at 90°C, and reacting in the NMP solvent atmosphere for 30 minutes.

The purity of the PbI₂, MAl, and BiI₃ materials used in this example is not less than 99%. The perovskite reaction material layer forms a perovskite material layer, and the second passivation precursor layer forms a second passivation layer. The perovskite film layer obtained in Example 2 includes a perovskite material layer and a second passivation layer, where the second passivation layer is located at a second interface of the perovskite material layer facing away from the PTAA hole transport layer.

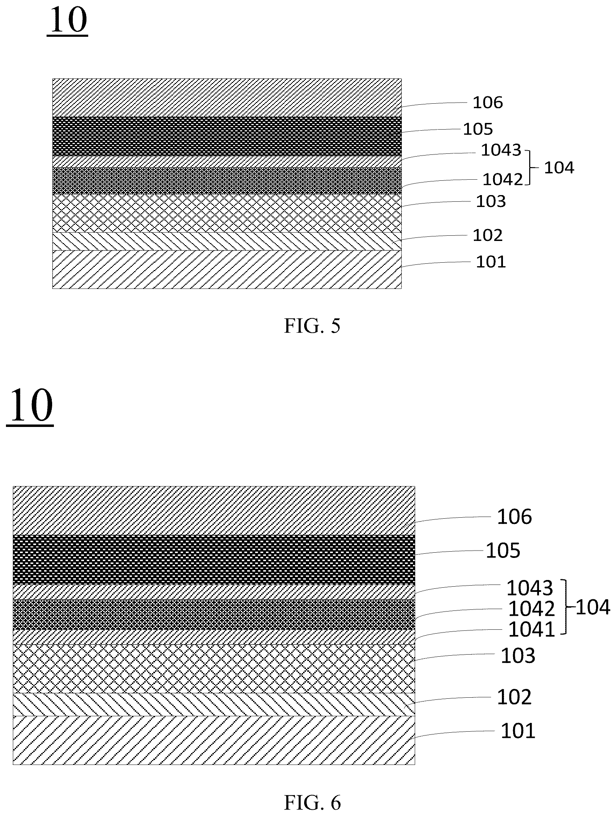

With the use of a semi-finished device including the perovskite film layer obtained in Example 2, the performance of the perovskite film layer prepared by the preparation method of Example 2 is verified. Referring to FIG. 5, a solar cell 10 includes a base 101, a conductive layer 102, a hole transport layer 103, a perovskite film layer 104, an electron transport layer 105, and an electrode 106 stacked in sequence. The base 101, the conductive layer 102, the hole transport layer 103, and the perovskite film layer 104 are each the semi-finished device including the perovskite film layer obtained in Example 2. The perovskite film layer 104 includes a perovskite material layer 1042 and a second passivation layer 1043, where the second passivation layer 1043 is located at an interface of the perovskite material layer 1042 close to the electron transport layer 105. The solar cell 10 in this example is an inverted solar cell.

### Comparative example 2:

This comparative example provides a preparation method of a perovskite film layer, including the following steps:
providing a substrate, where the substrate includes a textured silicon base, an ITO conductive layer, and a PTAA hole transport layer stacked in sequence;
spin-coating a 1.5 mol/L MAPbI₃ on a surface of the PTAA hole transport layer facing away from the textured silicon base at a speed of 5000 rpm, and annealing at a temperature of 100°C for 10 minutes; and then spin-coating a 0.3 mg/mL BiI₃ isopropanol solution at a speed of 4000 rpm, and annealing at a temperature of 100°C for 5 minutes.

The purity of the MAPbI₃ and BiI₃ materials used in Comparative example 2 is not less than 99%. Compared with the perovskite film layer obtained in Example 2, the perovskite film layer obtained in Comparative example 2 does not include a second passivation layer.

### Example 3:

This example provides a preparation method of a perovskite film layer, including the following steps:
providing a substrate, where the substrate includes a glass base, an ITO conductive layer, and a NiOₓ hole transport layer stacked in sequence;
depositing a 10 nm thick PBAI layer as a first passivation precursor layer on a side of the NiOₓ hole transport layer facing away from the glass base by a vapor deposition method; depositing a 300 nm thick PbI₂ layer, a 10 nm thick CsI layer, and a 150 nm thick FAI layer as perovskite reaction material layers on a surface of the PBAI layer facing away from the substrate; and then depositing a 10 nm thick InBr₃ layer as a second passivation precursor layer on a surface of the perovskite reaction material layer facing away from the substrate by a physical vapor deposition method to obtain an intermediate product; and
placing the intermediate product in a beaker, dropping a DMF solvent with a concentration of 8 mg/m³ into the beaker, heating to 100°C to form a DMF solvent atmosphere, and reacting in the DMF solvent atmosphere at 100°C for 15 minutes.

The purity of the PBAI, PbI₂, CsI, and FAI materials used in Example 3 is not less than 99%. The first passivation precursor layer forms a first passivation layer, the perovskite reaction material layer forms a perovskite material layer, and the second passivation precursor layer forms a second passivation layer. The perovskite film layer obtained in Example 3 includes a first passivation layer, a perovskite material layer, and a second passivation layer, where the first passivation layer is located at a first interface of the perovskite material layer close to the glass base, and the second passivation layer is located at a second interface of the perovskite material layer facing away from the glass base, the first interface and the second interface being opposite each other.

With the use of a semi-finished device including the perovskite film layer obtained in Example 3, the performance of the perovskite film layer prepared by the preparation method of Example 3 is verified. Referring to FIG. 6, a solar cell 10 includes a base 101, a conductive layer 102, a hole transport layer 103, a perovskite film layer 104, an electron transport layer 105, and an electrode 106 stacked in sequence. The base 101, the conductive layer 102, the hole transport layer 103, and the perovskite film layer 104 are each the semi-finished device including the perovskite film layer obtained in Example 3. The perovskite film layer 104 includes a first passivation layer 1041, a perovskite material layer 1042, and a second passivation layer 1043, where the first passivation layer 1041 is located at an interface of the perovskite material layer 1042 close to the hole transport layer 103, and the second passivation layer 1043 is located at an interface of the perovskite material layer 1042 facing away from the hole transport layer 103. The solar cell 10 in this example is an inverted solar cell.

### Comparative example 3:

This comparative example provides a preparation method of a perovskite film layer, including the following steps:
providing a substrate, where the substrate includes a glass base, an ITO conductive layer, and a NiOₓ hole transport layer stacked in sequence;
spin-coating a 3 mg/mL PBAI isopropanol solution on a surface of the NiOₓ hole transport layer facing away from the glass base at a rotation speed of 4000 rpm; continuing to spin-coat a 1.4 mol/L Cs_{0.05-0.2}FA_{0.8-0.95}PbI₃ at a rotation speed of 5000 rpm, and annealing at a temperature of 100°C for 15 minutes; and then continuing to spin-coat a 0.2 mg/mL InBr₃ isopropanol solution at a rotation speed of 4000 rpm, and annealing at a temperature of 100°C for 5 minutes.

The purity of the PBAI, Cs_{0.05-0.2}FA_{0.8-0.95}PbI₃, and InBr₃ materials used in Comparative example 3 is not less than 99%. Compared with the perovskite film layer obtained in Example 3, the perovskite film layer obtained in Comparative example 3 does not include a first passivation layer and a second passivation layer.

It should be noted that in the perovskite film layers of Comparative examples 1 to 3 each do not include the first passivation layer and/or the second passivation layer. If the first passivation layer and/or the second passivation layer need to be provided, both the first passivation layer and the second passivation layer require independent annealing treatments.

The solar cells using the perovskite film layers of Examples 1 to 3 and Comparative examples 1 to 3, are respectively subjected to photoelectric conversion efficiency tests and light aging tests. Test methods are described as follows.

### Photoelectric conversion efficiency test:

At 25°C, the solar cells assembled from the semi-finished devices including the perovskite film layers of Examples 1 to 3 and Comparative examples 1 to 3 were placed under sunlight with a light power density of 100 mW/cm² through a test fixture. Specifically, the test fixture and a Keithley 2400 digital source meter were connected using a four-wire method, A starting voltage was set to -0.2 V, a cutoff voltage was set to 1.2 V, and a scanning speed was set to 200 mV/s. Forward and reverse (reverse/forward) scanning was performed; and a short-circuit current density (Jsc), an open-circuit voltage (Voc), and a fill factor (FF) were recorded.

Then, the photoelectric conversion efficiency (PCE) of the solar cell was calculated, with a calculation formula being PCE=Jsc×Voc×FF/light power density×100%; and the obtained data were shown in Table 1.

### Light aging test:

Specific test process: At a light power density of 100 mW/cm² and 65°C, the solar cells assembled from the semi-finished devices including the perovskite film layers of Examples 1 to 3 and Comparative examples 1 to 3 were placed under sunlight and sealed in a nitrogen box, and the maximum power point voltage of the solar cell was dynamically monitored; and time, power, current, and voltage were recorded.

After the solar cell was removed, the above photoelectric conversion efficiency test was performed on the solar cell. Specifically, a test fixture and a Keithley 2400 digital source meter were connected using the four-wire method. A starting voltage was set to -0.2 V, a cutoff voltage was set to 1.2 V, and a scanning speed was set to 200 mV/s. Forward and reverse scanning was performed; and a short-circuit current density (Jsc), an open-circuit voltage (Voc), and a fill factor (FF) were recorded.

Then, the photoelectric conversion efficiency (PCE) of the solar cell after light aging was calculated and compared with the PCE of the solar cell before aging.

**Table 1: Components of perovskite film layers and performance parameters of solar cells of Examples 1 to 3 and Comparative examples 1 to 3**

| Sample | Perovskite film layer | Photoelectric conversion efficiency (%) | Percentage decrease in photoelectric conversion efficiency after light aging for 1000 hours (%) |
|---|---|---|---|
| Example 1 | First passivation layer: PEAI; | 9% | -30% |
| | Perovskite material layer: MASnI₃ | | |
| Comparative example 1 | No first passivation layer; | 5% | -70% |
| | Perovskite material layer: MASnI₃ | | |
| Example 2 | Second passivation layer: BiI₃; | 20% | -15% |
| | Perovskite material layer: MAPbI₃ | | |
| Comparative example 2 | No second passivation layer; | 17% | -60% |
| | Perovskite material layer: MAPbI₃ | | |
| Example 3 | First passivation layer: PBAI; | 23% | -10% |
| | Second passivation layer: InBr₃; | | |
| | Perovskite material layer: Cs_{(0.05-0.2})FA_{(0.8-0.95})PbI₃ | | |
| Comparative example 3 | No first passivation layer and second passivation layer; | 20% | -50% |
| | Perovskite material layer: Cs_{(0.05-0.2)}FA_{(0.8-0.95)}PbI₃ | | |

The results of Example 1 compared to Comparative example 1, Example 2 compared to Comparative example 2, and Example 3 compared to Comparative example 3 in Table 1 indicate that the solar cells using the perovskite film layers provided by this application have high photoelectric conversion efficiency and slow aging rates.

It can also be seen from the preparation methods of the perovskite film layers in the above Examples 1 to 3 that the preparation method of the perovskite film layer of this application can be completed by heating and annealing once, saving time and cost compared to repeated heating and annealing in the prior art.

In this application, a structure of a first passivation precursor layer/perovskite reaction material layer, a structure of a first passivation precursor layer/perovskite reaction material layer/second passivation precursor layer, or a structure of a perovskite reaction material layer/second passivation precursor layer is formed by deposition, and then a solvent atmosphere is utilized to provide a reaction environment, enabling the first passivation precursor layer and/or the second passivation precursor layer to react with the perovskite reaction material, avoiding the defect that each film layer needs to be annealed during the preparation process, achieving the preparation of the perovskite film layer, and providing a simple-process preparation method of a perovskite film layer.

In addition, since the preparation method of the perovskite film layer provided by this application avoids the defect that each film layer needs to be annealed during the preparation process and achieves the preparation of the perovskite film layer, the preparation cycles and costs of a perovskite light-absorbing layer are reduced, enabling large-scale continuous production.

Furthermore, by utilizing the solvent atmosphere to provide the reaction environment, the first passivation precursor layer and/or the second passivation precursor layer react with the perovskite reaction material, and the simultaneous reaction can enhance the crystallization process, reduce defects at grain boundaries, and improve the stability of the perovskite film layer.

Although this application has been described with reference to the preferred embodiments, various modifications to this application and replacements of the components therein with equivalents can be made without departing from the scope of this application. In particular, as long as there is no structural conflict, the technical features mentioned in the various embodiments can be combined in any manner. This application is not limited to the specific embodiments disclosed herein but includes all technical solutions falling within the scope of the claims.

## Claims

1. A preparation method of a perovskite film layer, comprising the following steps:
providing a substrate, wherein the substrate comprises a base and a transport layer disposed on the base;
depositing a perovskite reaction material layer on a side of the transport layer facing away from the base to obtain an intermediate product, wherein before depositing the perovskite reaction material layer, deposition of a first passivation precursor layer is further comprised, and/or after depositing the perovskite reaction material layer, deposition of a second passivation precursor layer is further comprised; and
placing the intermediate product in a solvent atmosphere for reaction.

2. The preparation method of a perovskite film layer according to claim 1, **characterized in that** the transport layer comprises an electron transport layer or a hole transport layer.

3. The preparation method of a perovskite film layer according to claim 1 or 2, **characterized in that** a material of the electron transport layer comprises at least one of TiO₂, SnO₂, and ZnO, and a material of the hole transport layer comprises at least one of poly[bis(4-phenyl)(2,4,6-trimethylphenyl)amine] (Poly[bis(4-phenyl)(2,4,6-triMethylphenyl)amine], PTAA), poly(3,4-ethylenedioxythiophene):poly(styrenesulfonate) (Poly(3,4-ethylenedioxythiophene):poly(styrenesulfonate), PEDOT:PSS), triphenylamine, carbazole phosphate, and NiOₓ,

4. The preparation method of a perovskite film layer according to any one of claims 1 to 3, **characterized in that** the first passivation precursor layer, the perovskite reaction material, and/or the second passivation precursor layer are deposited by a vapor deposition method.

5. The preparation method of a perovskite film layer according to any one of claims 1 to 4, **characterized in that** the solvent atmosphere comprises a polar solvent.

6. The preparation method of a perovskite film layer according to any one of claims 1 to 5, **characterized in that** the solvent atmosphere comprises at least one of vapor phases of N,N-dimethylformamide (N,N-Dimethylformamide, DMF), dimethyl sulfoxide (Dimethyl sulfoxide, DMSO), N-methylpyrrolidone (N-Methylpyrrolidone, NMP), dimethylacetamide (Dimethylacetamide, DMAC), 1,4-butyrolactone (1,4-Butyrolactone, GBL), and 1,3-dimethyl-2-imidazolidinone (1,3-Dimethyl-2-imidazolidinone, DMI).

7. The preparation method of a perovskite film layer according to any one of claims 1 to 6, **characterized in that** the solvent atmosphere is provided by a semi-closed container or a gas flow environment.

8. The preparation method of a perovskite film layer according to claim 7, **characterized in that** a solvent is added to the semi-closed container, and the semi-closed container is heated to form a solvent atmosphere.

9. The preparation method of a perovskite film layer according to any one of claims 1 to 8, **characterized in that** a concentration of the solvent atmosphere is 2-20 mg/m³.

10. The preparation method of a perovskite film layer according to any one of claims 1 to 9, **characterized in that** a material of the first passivation precursor layer and a material of the second passivation precursor layer are selected from at least one of an organic halide and a metal halide, and the material of the first passivation precursor layer is different from the material of the second passivation precursor layer.

11. The preparation method of a perovskite film layer according to claim 10, **characterized in that** the organic halide comprises at least one of benzylamine, phenylethylamine, diphenylamine, spermine, naphthylamine, and halogenated derivatives thereof.

12. The preparation method of a perovskite film layer according to claim 10 or 11, **characterized in that** the metal halide comprises halides of trivalent metal elements in the same period as Pb and Sn.

13. The preparation method of a perovskite film layer according to any one of claims 10 to 12, **characterized in that** the perovskite reaction material layer comprises BX₂ and AX, wherein B comprises at least one of Sn and Pb, A comprises at least one of Cs, FA, and MA, X comprises at least one of Cl, Br, and I, the organic halide is close to a side of the BX₂, and the metal halide is close to a side of the AX.

14. The preparation method of a perovskite film layer according to any one of claims 1 to 13, **characterized in that** a thickness of the first passivation precursor layer is 5-20 nm.

15. The preparation method of a perovskite film layer according to any one of claims 1 to 14, **characterized in that** a thickness of the second passivation precursor layer is 5-20 nm.

16. The preparation method of a perovskite film layer according to any one of claims 1 to 15, **characterized in that** a thickness of the perovskite reaction material layer is 400-800 nm.

17. The preparation method of a perovskite film layer according to any one of claims 1 to 16, **characterized in that** the base comprises at least one of a polyethylene terephthalate (polyethylene terephthalate, PET) base, a textured silicon base, or a glass base.

18. The preparation method of a perovskite film layer according to any one of claims 1 to 17, **characterized in that** a conductive layer is provided between the base and the transport layer.

19. A perovskite film layer, **characterized by** comprising:
a perovskite material layer; and
a first passivation layer and/or a second passivation layer,
wherein the first passivation layer is disposed on a surface of the perovskite material layer close to the base, the second passivation layer is disposed on a surface of the perovskite material layer facing away from the base, and a grain size of the perovskite material layer is greater than or equal to 2 micrometers.

20. A perovskite film layer, **characterized by** comprising a perovskite film layer obtained by the preparation method of a perovskite film layer according to any one of claims 1 to 18, wherein the perovskite film layer comprises:
a perovskite material layer; and
a first passivation layer and/or a second passivation layer,
wherein the first passivation layer is disposed on a surface of the perovskite material layer close to the base, and the second passivation layer is disposed on a surface of the perovskite material layer facing away from the base,

21. A solar cell, **characterized by** comprising the perovskite film layer according to claim 19 or 20 or a perovskite film layer prepared by the preparation method of a perovskite film layer according to any one of claims 1 to 18.
